(19)

Europäisches
Patentamt
European
Patent Office
Office européen
des brevets

(11) **EP 2 026 470 A1**

(12) **EUROPEAN PATENT APPLICATION**

(43) Date of publication:
**18.02.2009 Bulletin 2009/08**

(51) Int Cl.:
*H03M 13/09* (2006.01)    *H04L 1/00* (2006.01)

(21) Application number: **07016210.2**

(22) Date of filing: **17.08.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **Panasonic Corporation
Kadoma-shi
Osaka 571-8501 (JP)**

(72) Inventors:
• **Golitschek Edler von Elbwart, Alexander
63225 Langen (DE)**
• **Motozuka, Hiroyuki
Osaka 540-6207 (JP)**

(74) Representative: **Grünecker, Kinkeldey,
Stockmair & Schwanhäusser
Anwaltssozietät
Leopoldstrasse 4
80802 München (DE)**

(54) **Running cyclic redundancy check over coding segments**

(57)    In order to allow early stopping of codeblock decoding iterations, a cyclic redundancy check (CRC) is attached to each codeblock segment that pertains to the same transport block carrying information bits. The CRC for segment k is calculated for all bits within segments 1 to k. This allows also identifying cases of wrongly assumed CRC check results for segments 1 to k when the CRC attached to segment k+1 is evaluated.

500

DIVIDE AN INPUT DATA BLOCK
INTO N DATA SEGMENTS — S510

CALCULATE A CRC FOR A
FIRST DATA SEGMENT — S520

CALCULATE A K-TH CRC FOR EACH
DATA SEGMENT K — S530

ATTACH THE 1ST CRC TO THE 1ST
DATA SEGMENT AND EACH K-TH
CRC TO EACH DATA SEGMENT K — S540

FIG. 5

EP 2 026 470 A1

**Description**

TECHNICAL FIELD OF THE INVENTION

The present invention relates generally to error checking in digital systems, and more specifically, to packet transmission in a digital communication system from a source to a destination with error-detection codes such as cyclic redundancy check codes.

BACKGROUND OF THE INVENTION

Error checking is commonly used in digital communication systems, namely in streaming audio, video and audio/video communications, as well as storage systems for detecting errors in a message or a file that have been transferred or stored. A method of detecting such errors is to use cyclic redundancy check (CRC) techniques. The CRC performs a mathematical computation on a block of data, which consists in dividing an input message, file or data stream of a variable length by a particular number of a predetermined fixed-length, a divisor, and returning the remainder of the division as a result of the computation. The divisor is generally referred to as a "CRC polynomial" or a "generator polynomial" and the result of the computation (a "checksum") is generally referred to as a cyclic redundancy checksum value (CRC value).

Generally, the CRC value is computed for a data stream or data block at the source node and sent together with the data transferred to the destination node. When the data is received at or retrieved by the destination node, another CRC computation is performed for the received or retrieved data and the newly computed CRC checksum compared with the received CRC value. If the CRC values do not match, it is assumed that an error has occurred or that the received or stored data has been altered in some way.

The size of the CRC value is determined by the length of the CRC polynomial that is used in the computations. For instance, a CRC that uses a polynomial of order 16 will return a 16-bit CRC value. Since a CRC polynomial of order n applied to a data block of arbitrary length will be able to detect an error burst not longer than n bits, in general, a long polynomial is more likely to detect errors in the transmitted or stored data than a short polynomial.

Although CRC can be constructed with any finite field, common CRCs employ the finite field GF(2) to produce the CRC value, which is similar to binary division and is easy to implement using a register having the same length as the CRC polynomial. The register is used to compute the CRC value and store it, at least temporarily, after computation. The register is usually cleared before the division is performed and may then be initialized to all ones to prevents errors caused by extraneous zeros that may or may not be detected by the CRC check.

The details of the CRC calculation are well known and will not be detailed here. For instance, document 3GPP TS 36.212 v1.3.0, chapter 5.1.1, details a CRC calculation in which input bits to the CRC computation are denoted by $a_0,a_1,a_2,a_3,...,a_{A-1}$, and the parity bits by $p_0,p_1,p_2,p_3,...p_{L-1}$, $A$ being the size of the input sequence and $L$ being the number of parity bits. The parity bits are generated by a cyclic generator polynomial, such as the following cyclic generator polynomials:

$$g_{CRC24}(D) = [D^{24} + D^{23} + D^6 + D^5 + D + 1] \text{ for a CRC length } L = 24,$$

and

$$g_{CRC16}(D) = [D^{16} + D^{12} + D^5 + 1] \text{ for a CRC length } L = 16.$$

The encoding is performed in a systematic form, which means that in GF(2), the polynomial:

$$a_0 D^{A+23} + a_1 D^{A+22} + ... + a_{A-1} D^{24} + p_0 D^{23} + p_1 D^{22} + ... + p_{22} D^1 + p_{23}$$

yields a remainder equal to 0 when divided by $g_{CRC24}(D)$, and the polynomial:

$$a_0 D^{A+15} + a_1 D^{A+14} + ... + a_{A-1} D^{16} + p_0 D^{15} + p_1 D^{14} + ... + p_{14} D^1 + p_{15}$$

yields a remainder equal to 0 when divided by $g_{CRC16}(D)$.

The bits after CRC attachment are denoted by $b_0, b_1 b_2, b_3, ..., b_{B-1}$, where $B = A + L$. The relation between $a_k$ and $b_k$ is:

$$b_k = a_k$$

for $k$ = 0, 1, 2, ..., $A$-1

$$b_k = p_{(L-1-(k-A))} \text{ for } k = A, A+1, A+2, ..., A+L\text{-}1.$$

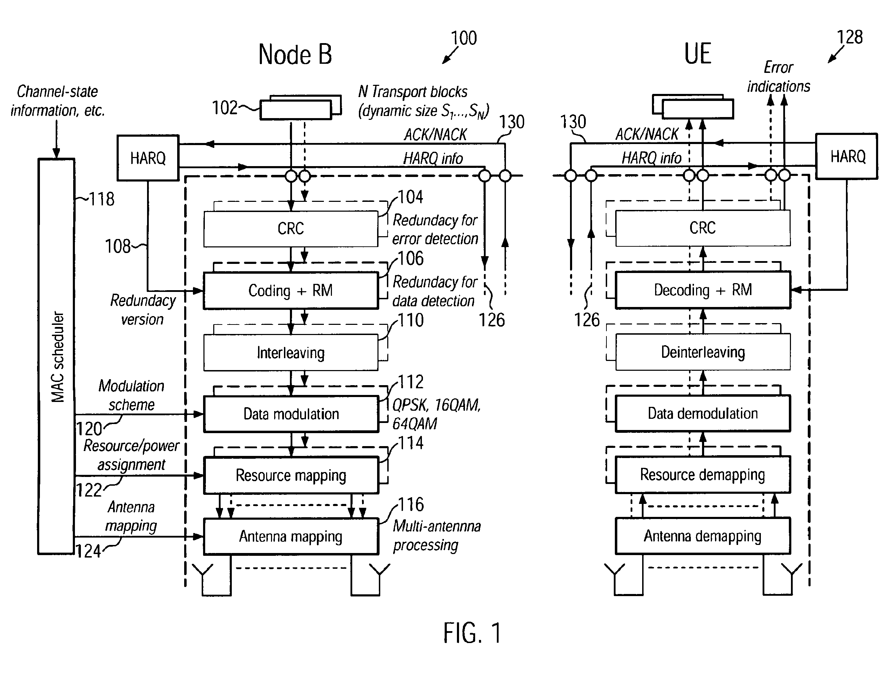

The use of cyclic redundancy check in the context of the 3rd Generation Partnership Project (3GPP), in particular the current relation between transport blocks and further functional blocks in the physical layer of 3GPP LTE (Long Term Evolution) is illustrated in Figure 1 for the downlink shared channel (DL-SCH). This relation is described in more detail in document 3GPP TS 36.300 v8.1.0.

Referring to Fig. 1, the DL-SCH physical-layer model is described based on the corresponding DL-SCH physical-layer-processing chain.

On the transmitter side (node B) 100, the processing chain initiates with the passing of high-layer data to/from the physical layer, in which N transport blocks of dynamic size $S_1, ..., S_N$ are delivered 102 to the physical layer once every transmission time interval (TTI). Desired redundancy for purposes of error detection 104, such as cyclic redundancy checksums, is then computed and a transport-block-error indication delivered to the higher layers.

In the processing step of coding and rate matching 106, the channel coding rate is implicitly given by the combination of transport block size, modulation scheme and resource assignment and the error control method. Most particularly, the redundancy version of the Hybrid Automatic Repeat Request (HARQ) supported by the physical layer is specified 108. In case of Incremental Redundancy HARQ, the corresponding Layer 2 Hybrid-ARQ process controls what redundancy version is to be used for the physical layer transmission for each TTI.

Within the DL-SCH physical-layer model, there is no control of interleaving by the higher layers 110. The processing steps that are relevant for the physical-layer model, e.g. in the sense that they are configurable by higher layers, are the steps of coding and rate matching 106, of data modulation 112, of resource mapping 114 and of antenna mapping 116.

The MAC Scheduler 118 decides the modulation scheme 120 to be used for the data modulation, such as QPSK, 16QAM and 64 QAM, and specifies an L2-controlled resource assignment 122 for the mapping to resource blocks. With respect to the last physical-layer processing step 116 (Multi-antenna processing), the MAC Scheduler 118 partly configures mapping 124 from assigned resource blocks (for each stream) to the available number of antenna ports.

With respect to the support for Hybrid-ARQ-related signaling, the DL-SCH model also captures the transport via physical layer of Hybrid-ARQ related information 126 associated with the DL-SCH, to the peer HARQ process at the receiver side 128, such as at the user equipment (UE), and the transport via physical layer of corresponding HARQ acknowledgements 130 to DL-SCH on the transmitter side 100.

However, it should be noted that the signaling of transport-format and resource-allocation is not captured in the physical-layer model. At the transmitter side 100, this information can be directly derived from the configuration of the physical layer. The physical layer then transports this information over the radio interface to its peer physical layer, presumably multiplexed in one way or another with the HARQ-related information 126. On the receiver side 128, this information is, in contrast to the HARQ-related information 126, used directly within the physical layer for DL-SCH demodulation 132, decoding 134, etc., without passing through higher layers.

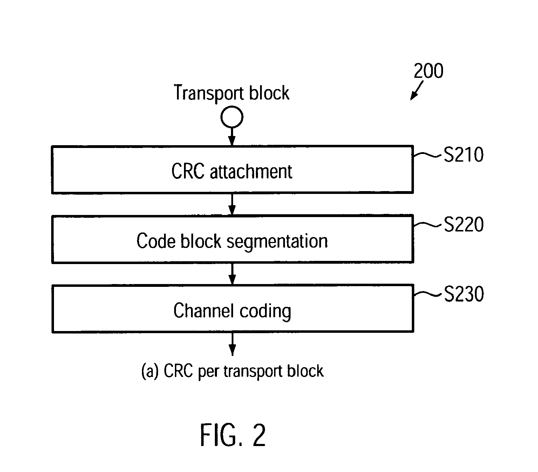

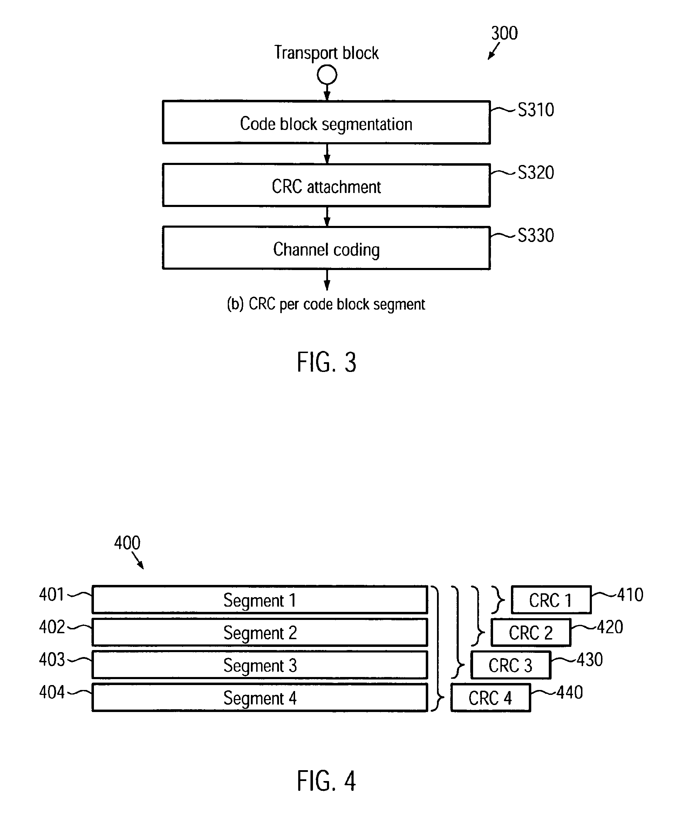

The type of CRC attachment is a main open issue on the channel coding chain and has been intensively discussed, such as in document R1-072927, during the 3GPP TSG RAN1 49bis Meeting. This document discussed the main characteristics of the different types of CRC attachment, which are categorized into two schemes: (a) CRC attachment per transport block and (b) CRC attachment per code block segment, which are illustrated in Figs 2 and 3, respectively. The CRC per transport block scheme consists in attaching a single CRC to the transport block prior to the segmentation into code blocks, while in the CRC per code block segment scheme the transport block is segmented first in code blocks or segments and a CRC is attached to each segment.

A major feature of CRC per transport block is small overhead. The overhead may be 0.4% in the worst case since segmentation is used only for packet sizes larger than 6144. A main feature of CRC per code block (i.e. per segment) is power saving at the user equipment side by stopping the turbo decoding if CRC is negative (NG). However, it depends on the target block length error (BLER). A hybrid scheme of using 8-bit CRC for code block segment was also proposed since 24-bit CRC per code block may be seen as overkill.

Several CRC techniques employing one or the other CRC attachment schemes have been proposed.

Patent application US5282215A describes a synchronization circuit for ATM cells transferred in an ATM communication system, in which the synchronization circuit receives and holds in a bit serial manner the input bit trains constituting the received ATM cells. This is done by means of a shift register unit. A continuous CRC arithmetic unit performs a CRC operation in a bit serial manner on the held input bit trains in accordance with a simplified CRC operation process. The synchronization circuit performs the necessary synchronization control upon receiving the CRC arithmetic operation result, thereby enabling CRC arithmetic operations to be performed continuously on the headers in the ATM cells.

However, according to the patent application US 5282215A, none of the output bits (CRC bits) stored in the storage sections of the CRC arithmetic unit are transmitted to the receiving chain. In addition, the CRC length or generator polynomial is not varied between segments.

Similar to US 5282215A, United States Patent US 7243289 describes a method to compute a final CRC for an entire block of data by segmenting the block into segments, calculating intermediate CRCs for each segment, and forming a final CRC from the intermediate CRCs. A residue table T is calculated that has 'R' entries, where the CRC is R-bits in length, and the final CRC for the data block is computed as the sum of the effective CRC and the partial CRC of the second segment.

However, none of the intermediate CRCs is transmitted to the receiver by attaching them to the segments prior to FEC encoding. In addition, content of the CRC register is not kept between segments as well as the CRC length or generator polynomial between segments is always the same.

Both prior arts US 5282215A and US 7243289 have the drawback that since the data transport block is transmitted with one, final attached CRC, if a data segment of an encoded data block is corrupted during transmission, the decoding iterations have to be completed for the whole data transport before the error is detected. In addition, since they employ a CRC with the same length or the same generator polynomial for different segments, it is not possible to detect CRC mis-detections during a certain segment.

SUMMARY OF THE INVENTION

The present invention aims at overcoming the disadvantages and shortcomings of the above described prior arts and an object thereof is to provide a method and apparatus for implementing the method, which combines the advantage of small overhead with the possibility of stopping turbo decoding if CRC is not good, and to allow early stopping of the decoding process at the receiver side 128 in the following situations:

· Early stopping within turbo decoding iterations per segment if CRC is OK ("Micro-Stop")

· Early stopping of segment decoding if CRC of a single segment after all decoding iterations is NG ("Macro-Stop")

A further object of the present invention is to make the detection of CRC mis-detections during a certain segment possible when checking the CRC attached to another segment.

The above objects are solved by the subject matter of the independent claims. Advantageous embodiments of the present invention are defined by the dependent claims.

According to an advantageous embodiment, the present invention provides a method of generating a checksum value for data input in a digital system, the method comprising the steps of dividing the input data into n data segments indexed 1 to n, wherein n is an integer, of calculating a first checksum for a first data segment of the n data segments using a total number of bits of the first data segment and producing a first checksum value, of calculating a checksum for at least a data segment indexed k of the n data segments and producing a checksum value indexed k, said checksum for data segment indexed k being calculated using the total number of bits of the data segments indexed 1 to k, wherein k is an integer, and of attaching the first checksum value to the first data segment and said checksum value indexed k to the data segment indexed k.

In a further embodiment, the number n is an integer greater than 1, and the number k is an integer ranging from 2 to n.

In a further embodiment, the step of calculating the checksum for data segment indexed k comprises using the total number of bits of the data segments indexed 1 to k and at least a checksum of a preceding data segment indexed (k-p), wherein p is an integer ranging from 1 to (k-1).

In another advantageous embodiment, the step of calculating comprises calculating the $k^{th}$ checksum for each data segment indexed k of the n data segments.

In a further embodiment, each calculating step performs cyclic redundancy check computations.

In a further embodiment, the checksum for data segment k is a running checksum, the running checksum for the data segment indexed k comprising the result of the running checksum for the preceding data segment indexed (k-1) and the checksum calculated using the total number of bits of the data segment indexed k, and the running checksum for the first data segment is calculated using only the total number of bits of the first data segment.

In another embodiment, the method comprises setting all cyclic redundancy check shift registers of the digital system to zero before computing the checksum for the first data segment, and maintaining the cyclic redundancy check shift registers with their value from the segment indexed (k-1) for computing the check sum for the data segment indexed k.

In another embodiment, said cyclic redundancy check computation comprises using for at least one of the n data segments a polynomial generator that is different from the polynomial generator used for at least one other of the n data segments.

In another embodiment, said cyclic redundancy check computations comprise using only polynomial generators with the same polynomial order.

In another embodiment, said cyclic redundancy check computations comprise using a first polynomial generator for each of the odd-numbered data segments and a second cyclic redundancy check polynomial generator for each of the even-numbered data segments.

The present invention also provides a method of generating a checksum value for data input in a digital system, the method comprising the steps of dividing the input data into n data segments, n being an integer greater than 1, of forming at least one data block comprising at least two consecutive data segments of the n data segments, of calculating a checksum for the at least one data block by using a total number of bits of the data segments comprised in the respective data block, and producing a checksum value for the respective data block, and of attaching the checksum value produced for the at least one data block to a data segment comprised in the respective data block.

In a further embodiment, the calculating step performs cyclic redundancy check computations.

In a further embodiment, the calculating step comprises calculating a running checksum for the at least one data block.

In a further embodiment, the forming step comprises forming consecutive blocks of data segments, each block comprising at least two consecutive data segments, the calculating step comprises calculating a running checksum for each data block, and producing a running checksum value for each data block, and the attaching step comprises attaching the running checksum value produced for each data block to the last segment comprised in the respective data block.

In another advantageous embodiment, the method further comprises the steps of calculating a checksum for at least one of the data segments that are not comprised in a data block by using the total number of bits of the respective data segment, and producing a data segment checksum value for the respective data segment, and attaching the data segment checksum value to the respective data segment.

In a further embodiment, the step of calculating the checksum of a data block comprises using the total number of bits of the data segments comprised in the respective data block and at least a checksum calculated for a preceding data block and/or a data segment checksum calculated for a preceding data segment not comprised in the formed data blocks.

In another advantages embodiment, the method further comprises the step of calculating a checksum for at least one of the n data segments that are comprised in a data block by using the total number of bits of the respective data segment, and producing a data segment checksum value for the respective data segment, and the step of attaching the data segment checksum value to the respective data segment.

In a further embodiment, in the attaching step, only a portion of the respective checksum value is attached to the respective data segments except for the last data segment.

In a further embodiment, each data segment of the n data segments are consecutive, non-overlapping data segments of a predetermined size and the first data segment is the left-most data segment of the segmented input data.

The present invention also provides an apparatus for generating a checksum value for data input in a digital system, the apparatus comprising a processing section for dividing the input data into n data segments indexed 1 to n, n being an integer, a checksum calculator for calculating a first checksum for a first data segment of the n data segments using a total number of bits of the first data segment and producing a first checksum value and for calculating a checksum for at least a data segment indexed k of the n data segments and producing a checksum value indexed k, said checksum for data segment indexed k being calculated using the total number of bits of the data segments 1 to k, wherein k is an integer, and an attaching section for attaching the first checksum value to the first data segment and said checksum value indexed k to the data segment indexed k.

Finally, in another advantageous embodiment the present invention provides an apparatus for generating a checksum value for data input in a digital system, the apparatus comprising a processing section for dividing the input data into n data segments, n being an integer, and forming at least one data block comprising at least two consecutive data segments, a check-sum calculator for calculating a checksum for the at least one data block by using the total number of bits of the data segments comprised in the respective data block, and producing a checksum value for the respective data block, and an attaching section for attaching the checksum value produced for the at least one data block to a data segment comprised in the respective data block.

A technical advantage of the present invention with respect to the cited prior arts lie in the "later" running CRC can detect miss-case when information part and CRC part of "earlier" segments have bit errors.

In addition, the present invention allows combining the technical advantages of small overhead with the early stop of decoding. Such as in the CRC per code block segment scheme, the present invention makes possible to stop the decoding early if a CRC attached to a segment is detected as erroneous after the maximum number of iterations. It also makes possible to stop early the decoding iteration of a segment if the CRC attached to the segment is detected as correct. This advantage cannot be achieved by the CRC per transport block scheme.

On the other hand, according to the present invention, CRC attached to the last segment is identical to the CRC attached to the transport block in the CRC per transport block scheme, therefore providing the same information. In contrast, in the CRC per code block segment, the CRC attached to the last data segment reflects only information on the least data segment.

BRIEF DESCRIPTION OF THE FIGURES

Further features and advantages will become apparent from the following and more particular description of the invention as illustrated in the accompanying drawings, in which:

**Fig. 1** shows a flow-chart diagram illustrating the DL-SCH physical-layer model at the node B side and at the user equipment side within the 3GPP LTE;

**Fig. 2** shows a flow-chart diagram illustrating a scheme of CRC attachment per transport block scheme;

**Fig. 3** shows a flow-chart diagram illustrating a scheme of CRC attachment per code block segment;

**Fig. 4** shows a schematic representation of a CRC attachment scheme according to an embodiment of the invention, which uses attachment of CRC per segment;

**Fig. 5** shows a flow-chart diagram illustrating a method for generating a checksum value according to an embodiment of the invention;

**Fig. 6** shows a schematic representation of an example of a shift register for calculating the CRC according to an embodiment of the invention;

**Fig. 7** shows a table that illustrates a comparative analysis of the overhead obtained when using prior art solutions and a solution according to the invention;

**Fig. 8** shows a schematic representation of a CRC attachment scheme according to another advantageous embodiment of the invention;

**Fig. 9** shows a schematic representation of a CRC attachment scheme according to another advantageous embodiment of the invention.

**Fig. 10** shows a flow-chart diagram illustrating a method for generating a checksum value according to advantageous embodiments of the invention.

DETAILED DESCRIPTION OF THE INVENTION

Advantageous embodiments of a method and apparatus for generating a checksum value for data input in a digital system constituted according to the invention will now be described in further detail with reference to the accompanying drawings. In the following, the invention will be described with reference to checksums calculated using cyclic redundancy check (CRC) techniques, although computation algorithms other than the CRC algorithm could also be envisaged.

Fig. 4 shows a schematic representation of a CRC attachment scheme according to a first embodiment of the invention, which uses attachment of CRC per data segment. In the illustrated example, an input data stream 400 of a variable number of bits is segmented into four segments of data 401, 402, 403, 404, of a predetermined size.

Assuming the input digital data 400 comprises 4m bits and is divided into the four data segments 401, 402, 403, 404, of equal size, each data segment will have m bits in length. However, the number and size of the data segments into which the input data 400 is segmented is not limited. The input digital data 400 may be segmented into a plurality of data segments of the same size or some of the data segments may have different sizes.

Each data segment 401, 402, 403, 404, is then submitted to CRC computations for generating a partial CRC value 410, 420, 430, 440, respectively, for each data segment.

Each partial CRC value 410, 420, 430, 440, is then attached to the respective data segments 401, 402, 403, 404.

An additional aspect of the present invention is that the partial CRC values are transmitted to the receiver by attaching them to the segments prior to FEC encoding, and that the content of the CRC register is kept between segments. This aspect is not present in none of the prior arts cited above.

Another important aspect of the present invention lies in the data and method used for computing the partial CRC values to be attached to the respective data segment.

Referring to Fig. 4, the CRC value 410 attached to the first data segment 401 is a normal CRC, that is a CRC checksum that is calculated using a total number of data bits from the first data segment 401. However, the CRC value 420 attached to the data segment 2 that follows the first data segment 401, is based on a total number of bits of segment 2 and of the preceding segment 1. Similarly, the CRC value 440 attached to the last data segment 404 depends on the respective data segment 404 as well as on the data bits from all preceding segments, from the first segment 401 to the immediately preceding segment 403.

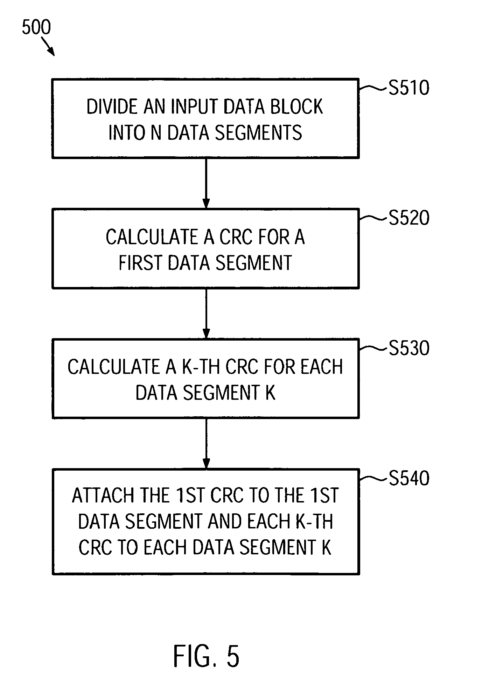

The details of the computation of the partial CRC values 410, 420, 430, 440 according to the first embodiment will now be described with reference to Fig. 5.

Fig. 5 shows a flow-chart diagram illustrating exemplary steps of a method 500 for generating a checksum value according to the first embodiment of the invention.

Referring to Figs. 4 and 5, once a block of digital data or a data stream 400 is input in the digital system, the method 500 begins by a step S510 of dividing the input digital data 400 into a plurality of n data segments of a certain size, n being any integer, preferably greater than 1. In case of n equal to 1, the functionality of segmentation S510 is simplified to passing the input through to the output. The input data 400 may be transmitted from a streaming media source or retrieved from a storage device. The digital data 400 may be received using a connection-oriented protocol, such as TCP, or a connectionless protocol, such as UDP, or it may be stored in the digital system or in an external storage device. Examples of input data 400 include audio data, video data, or audio and video data.

In step S510, the input data block 400 is sequentially segmented into a series of n data segments sequentially indexed or numbered from 1 to n. Preferably, the data segments are indexed starting from the first data segment or simply data segment 1, which is the left-most data segment or the top-most data segment in the segmented input data block 400, to data segment n, which is the right-most data segment or the bottom-most data segment. The series of n data segments is preferably a series of non-overlapping, consecutive data segments of a predetermined size, with all data segments having the same bit length. However, the input data block 400 may also be segmented into multiple data segments of different size.

In step S520, a normal CRC value is calculated for a first data segment, preferably for the left-most or top-most data segment 401 of the segmented input data 400 block, using a total number m of bits of the first data segment 401 and a predetermined CRC polynomial $g(x)$. In the next step S530, a sequential computation of a CRC for each one of the other data segments is performed. For instance, referring to the example illustrated in Fig. 4, the CRC2 value for the second data segment 402 is calculated using the total number of bits from the first segment 401 and from the second segment 402.

However, it is understood that the segments for which the method performs the CRC calculation can be selected as desired. In generic terms, assuming the input data block 400 is divided into n data segments, the sequential step S530 calculates a CRC value for each k-numbered data segment, the index k being an integer that ranges from 2 to n, and produces a CRC value for data segment k, that is, a CRC value indexed k. This CRC value, which is the CRC computed for the data segment k, is calculated using a total number of bits of the data segment k and using the total number of bits from the data segments 1 to (k-1). Although in the preferred embodiment the CRC values are calculated for each data segment k, the calculation step S530 may calculate a CRC value for just one or a few data segments other than the first data segment 401. It is obvious to those skilled in the art that in case n equals 1, the functionality of step S530 is void.

In step S540, the first CRC value 410 is attached to the first data segment 401 and each computed CRC value for data segment k is attached to the respective data segment k.

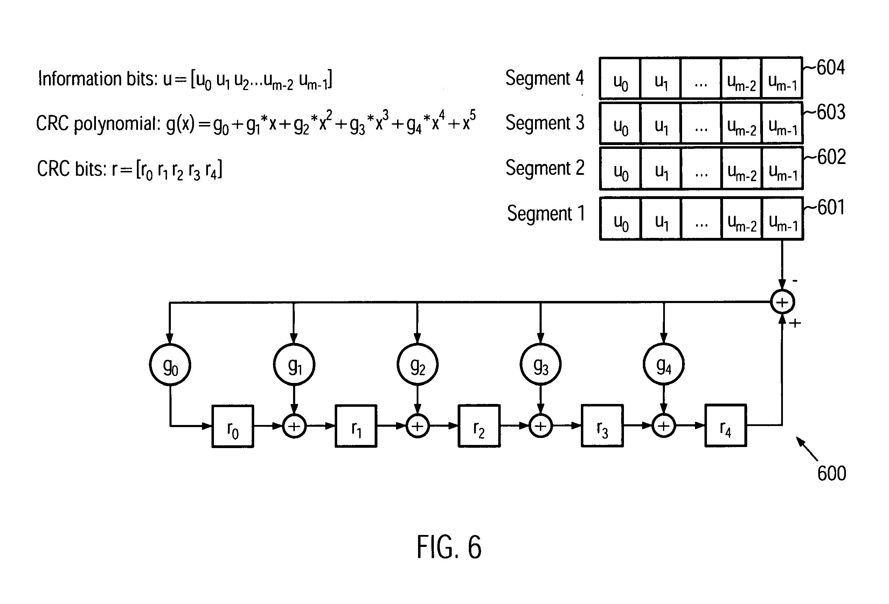

A standard technique for implementing the computation of the CRCs according to the invention consists in employing a n-bit feedback shift register circuit 600. Figure 6 illustrates an example of a sheet register for performing the CRC calculation method according to the first embodiment of the invention. In the illustrated example, CRC computations are performed in four data segments 601, 602, 603, 604. Each data segment is represented as a vector u of m-bit length, with components or information bits $u_0$, $u_1$,..., $u_{m-1}$. When using a CRC polynomial g(x) of order 5, the CRC value generated for each data segment u is also a 5-bit CRC value r, with components or information bits $r_0$, $r_1$,..., $r_4$.

The circuit operates in a fashion similar to a manual long division. The storage elements in Fig. 6 hold the coefficients $g_i$ of the divisor corresponding to the respective powers of x, i being an integer between 0 and n-1. For each cycle of the division algorithm, the $r_{i-1}$ coefficient at the end of one cycle will become the $r_i$ coefficient for the next cycle. For a generator polynomial of order n-1, only the n next-most-significant bits can be affected by the subtraction, so only n-1 storage elements are needed. After each subtraction (actually modulo-2 addition), the resulting modified coefficients of the divisor are stored in the shift register.

According to the invention, before calculating the CRC for the first data segment, all CRC shift registers are initialized by setting them all to zero. For the calculation of the CRC value for the next data segment k, the CRC shift registers are not initialized but are allowed to keep the CRC value calculated for the preceding (k-1) data segments, r = [$r_0$ $r_1$ $r_2$ $r_3$ $r_4$ ], obtained on the preceding computation for segment (k-1). Consequently, the CRC value computed for data segment k is identical to the single CRC value calculated for information bits from data segments 1 to k.

In an alternate embodiment, the step of calculating the CRC for data segment k may comprise using the total number of bits of the data segments 1 to k and the CRC value calculated for any of the preceding (k-p) data segments, that is, value CRC(k-p), in which p is an integer between 1 and k-1. For example, this can be realized by including the CRC calculated for segment (k-p-1) to data segment (k-p), before the CRC for segment (k-p) is calculated. Said inclusion to a "subsequent" data segment may for example be facilitated by pre-pending, appending, or otherwise insert the respective CRC bits into the respective "subsequent" data segment within step S520 and step S530. Obviously, this method increases the effective data segment size; therefore, it may be preferable in this embodiment to choose the sizes of the n data segments during step S510 such that the resulting effective segment sizes after step S540 are equal.

Alternatively, in order to improve the efficiency of the CRC computations, the CRC value already calculated for the first data segment 401 can be used in the computation of the second CRC value of the second data segment 402, for example, as the initial value of the CRC shift registers seen in Fig. 6. The CRC values of successive data segments can then be calculated as running checksums. In this configuration, the CRC value of the first data segment is computed using all the data bits from the first data segment and is kept or stored to be used in the computation of the CRC value of the following data segment. This recursive computation is then extended to the next, successive, data segments. In general terms, the CRC value for data segment k, in which the index k is an integer than can be varied between 2 and n by successive increments of 1, is computed using the total number of bits of the data segment k and the previously computed CRC value(s) of the preceding data segment (k-1). Each of the calculated CRC values is attached to the respective data segment k.

In the embodiment illustrated in Fig. 6, all data segments u have the same length m and are operated using the same CRC polynomial. However, the present invention also envisages the use of different CRC polynomials for operating different data segments of the segmented input data block. For example, a first data segment may be operated with a CRC polynomials that differs on the polynomial degree or size from the CRC polynomial for computing the CRC to be attached to other data segments. In addition, the CRC polynomials used for computing the CRC of different data segments may have the same size but have different coefficients. For instance, the method 500 may employ two different CRC polynomials of the same size, $g_A(x)$ and $g_B(x)$, for operating two sub-series of the n data segments, such as a sub-series of odd-numbered data segments and a sub-series of even-numbered data segments. The advantage of using different CRC generator polynomials for different data segments is that a "later" CRC can detect miss-case when the information part of "earlier" segments has bit errors.

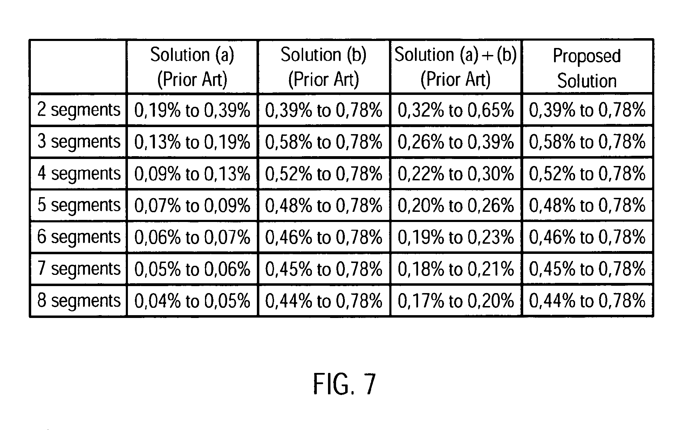

Fig. 7 shows a table that illustrates a comparative analysis of the overhead obtained when using the solution according to the first embodiment of the present invention and the prior art solutions: (a) CRC attachment per transport block, (b) CRC attachment per code block and an hybrid (a) + (b) scheme. Also compared is the overhead obtained as a function of the number of data segments used in the CRC computations. As illustrated in Fig. 7, the overhead associated with the solution of the present invention is comparable to the overhead associated with prior art scheme (b), independently of the number of data segments. In addition, according to the invention, the overhead does not vary significantly with the number of data segments, lying between a minimum of 0.39% to 0.78% for two segments and a maximum of 0.58% to 0.78% for eight data segments. In contrast thereto, the overheads obtained with the prior art scheme (a) and the hybrid scheme (a)+(b) are significantly lower and show a tendency to decrease with the increase of the number of data segments.

According to an alternative embodiment, the computed CRC are not running and/or attached over all data segments. This allows reducing overhead and saving on the computational complexity, with respect to the previously described embodiments.

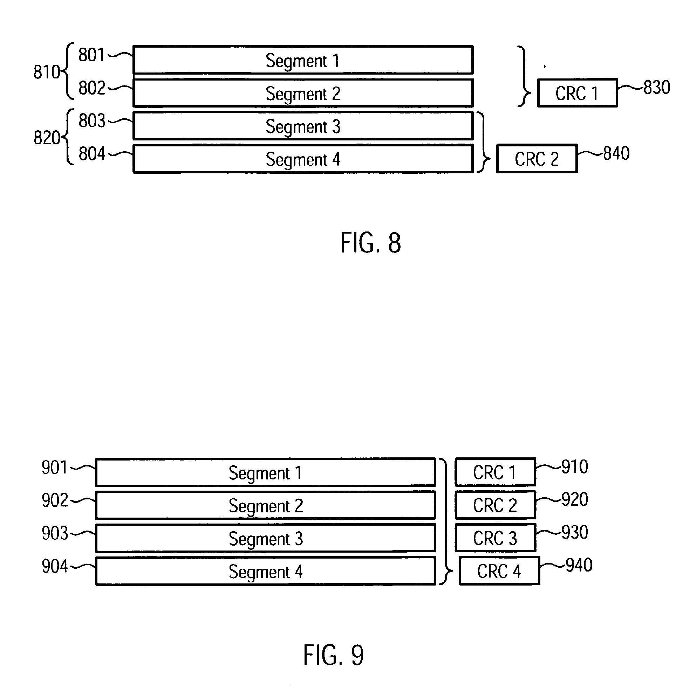

Fig. 8 shows a schematic representation of a CRC attachment scheme according to an alternative embodiment, in which CRC is attached over a limited number of data segments. In the illustrated example, the input data block 400 is segmented into four data segments 801, 802, 803, 804. However, a CRC is neither computed nor attached to every data segment. Instead, the CRC is computed only for a group of consecutive data segments and the calculated CRC attached to the last data segment of the respective data block. In the example illustrated in Fig. 8, the first two data segments 801, 802 are computationally treated has forming a data block 810 and a CRC value is calculated based on the total number of data bits from data segments 801 and 802. Similarly, the CRC value attached to the fourth segment 804 is computed based on the total number of data bits from data segments 803 and 804, which are treated as forming a second data block 820. These data blocks 810, 820 are not to be construed as an additional segmentation of the input data 400 but only as defining a group of data segments that is used on the computation of each CRC value.

In the example illustrated in Fig. 8, the formed data blocks comprise the same number of data segments. Generally, the n data segments may be arranged in data blocks that comprise the same or a different number of data segments. In either case, a CRC value is computed for each data block using all the data bits from the data segments comprised in the respective data block. The CRC value calculated for each data block is then attached only to a predefined data segment of the respective data block, for instance, the last data segment.

This embodiment combines the advantage of using a reduced number of pre-selected data segments for attaching CRC values while reflecting in each attached CRC the data bit information from preceding data segments, and is most advantageous if a subsequent FEC functionality is executed per data segment.

Fig. 9 shows a schematic representation of a CRC attachment scheme according to another advantageous embodiment of the invention, in which a running CRC value is attached to a limited number of segments while a normal cyclic redundancy checksum 910, 920, 930 is attached to the other data segments 901, 902, 903. The normal CRC 910, 920, 930 is calculated using only the total number of data bits from the data segment, and is referred to as a data segment checksum. In the example illustrated in Fig. 9, only the fourth data segment 904 is attached with a CRC 940 computed using the total number of data bits from the fourth segment and the total number of data bits from all preceding data segments. This configuration has the advantage of allowing a higher amount of parallelization.

In a further development, a more than one data segment can be selected for being attached with a running CRC.

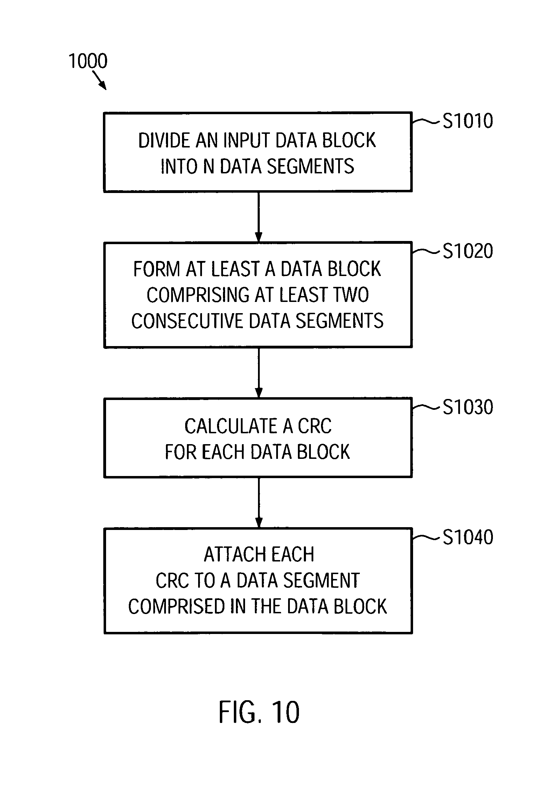

Fig. 10 shows a flow-chart diagram, which illustrates a method 1000 for generating a checksum value according to the embodiments previously described with reference to Figs. 8 and 9.

The method 1000 begins by a step S1010 of dividing the input data 400 block into n data segments, which is followed by a step S1020 of forming at least a data block comprising at least two consecutive data segments. The data block merely specifies the group of data segments that will be used in next step S1030 of calculating the CRC. The CRC is then calculated for each one of the data blocks by using a total number of bits of the data segments comprised in the respective data block, and a checksum value for the respective data block is produced. The checksum value produced for the data block is then attached S1040 to a data segment comprised in the respective block. Preferably, the data segment to which the CRC is attached is the last or the right-most data segment of each data block.

The method 1000 may be further developed in that the CRC for the data block is calculated as a running checksum over the data segments comprised in the data block.

In addition, as described previously, the method 1000 may comprise forming or arranging the n data segments into consecutive data blocks, each block comprising at least two consecutive data segments. In this configuration, the calculating step S1030 may comprise calculating a running checksum for each data block, each running checksum being attached to the last segment comprised in the respective data block.

Since the present invention also covers the possibility that not all of the n data segments are arranged in the data blocks, it may be envisaged to calculate a normal checksum for at least one of such data segments by using the total number of bits of the respective data segment and to attach the calculated checksum to the respective data segment.

In addition, the step S1030 of calculating the checksum of a data block may comprise using the total number of bits of the data segments grouped in the respective data block and at least a checksum calculated for a preceding data block and/or a checksum calculated for a preceding data segment that is not comprised in the data blocks.

Moreover, since according to the advantageous embodiment, the checksum calculated for a data block is only attached to one of the data segments comprised in the data block, the calculating step S1030 may also comprise calculating a data segment checksum for at least one of the data segments comprised in a data block and attaching the checksum value to the respective data segment.

In a further development of the method 1000, different CRC polynomials can be used for computing the CRC values of different data blocks data and/or segments.

In the previous embodiment, the attaching step S540, S1040 has been described as attaching the computed CRC values to the respective data segments. However, the present invention also envisages that not all bits but only a portion of the CRC value is attached to the respective data segments. For example, if the CRC computations use a polynomial of size 16, a 16-bit CRC is obtained and attached to the respective data segment. It may be then envisaged that for all segments except for the last segment, only some of these bits are attached to the segments. This can be interpreted as puncturing a part of the checksum. The benefit is that fewer overhead is required for those segments, and only a single CRC calculation unit (per generator polynomial) needs to be implemented and/or executed.

The present invention also provides an electronic circuit or apparatus comprising hardware circuitry specially adapted to perform the above presented methods, as well as and general-purpose hardware circuitry controlled by program instructions for generating the CRC values according to the above described methods.

## Claims

1. A method of generating a checksum value for data input in a digital system, the method comprising the steps of:

   dividing the input data into n data segments indexed 1 to n, wherein n is an integer;
   calculating a first checksum for a first data segment of the n data segments using a total number of bits of the first data segment and producing a first checksum value;
   calculating a checksum for at least a data segment indexed k of the n data segments and producing a checksum value indexed k, said checksum for data segment indexed k being calculated using the total number of bits of the data segments indexed 1 to k, wherein k is an integer; and
   attaching the first checksum value to the first data segment and said checksum value indexed k to the data segment indexed k.

2. The method according to claim 1, wherein
   said number n is an integer greater than 1, and
   said number k is an integer ranging from 2 to n.

3. The method according to claim 1 or 2, wherein
   the step of calculating the checksum for data segment indexed k comprises using the total number of bits of the data segments indexed 1 to k and at least a checksum of a preceding data segment indexed (k-p), wherein p is an integer ranging from 1 to (k-1).

4. The method according to anyone of claims 1 to 3 , wherein
   the step of calculating comprises calculating the checksum for each data segment indexed k of the n data segments.

5. The method according to any one of claims 1 to 4, wherein each calculating step performs cyclic redundancy check computations.

6. The method according to any one of claims 1 to 5, wherein
   the checksum for data segment indexed k is a running checksum, the running checksum for the data segment indexed k comprising the result of the running checksum for the preceding data segment indexed (k-1) and the checksum calculated using the total number of bits of the data segment indexed k, and
   the running checksum for the first data segment is calculated using only the total number of bits of the first data segment.

7. The method according to claim 6, further comprising:

   setting all cyclic redundancy check shift registers of the digital system to zero before computing the checksum for the first data segment; and
   maintaining the cyclic redundancy check shift registers with their value from the segment indexed (k-1) for computing the checksum for the data segment indexed k.

8. The method according to any one of claims 5 to 7, wherein:

   said cyclic redundancy check computation comprises using for at least one of the n data segments a polynomial generator that is different from the polynomial generator used for at least one other of the n data segments.

9. The method according to claim 8, wherein said cyclic redundancy check computations comprise using only polynomial generators with the same polynomial order.

10. The method according to claim 8 or 9, wherein
    said cyclic redundancy check computations comprise using a first polynomial generator for each of the odd-numbered data segments and a second cyclic redundancy check polynomial generator for each of the even-numbered data segments.

**11.** A method of generating a checksum value for data input in a digital system, the method comprising the steps of:

   dividing the input data into n data segments, n being an integer greater than 1;
   forming at least one data block comprising at least two consecutive data segments of the n data segments;
   calculating a checksum for the at least one data block by using a total number of bits of the data segments comprised in the respective data block, and producing a checksum value for the respective data block; and
   attaching the checksum value produced for the at least one data block to a data segment comprised in the respective data block.

**12.** The method according to claim 11, wherein
   the calculating step performs cyclic redundancy check computations.

**13.** The method according to claim 11 or 12, wherein
   the calculating step comprises calculating a running checksum for the at least one data block.

**14.** The method according to claim 11 or 12, wherein:

   the forming step comprises forming consecutive blocks of data segments, each block comprising at least two consecutive data segments,
   the calculating step comprises calculating a running checksum for each data block, and producing a running checksum value for each data block, and
   the attaching step comprises attaching the running checksum value produced for each data block to the last segment comprised in the respective data block.

**15.** The method according to any one of claims 10 to 14, further comprising the steps of:

   calculating a checksum for at least one of the data segments that are not comprised in a data block by using the total number of bits of the respective data segment, and producing a data segment checksum value for the respective data segment; and
   attaching the data segment checksum value to the respective data segment.

**16.** The method according to any one of claims 11 to 15, wherein
   the step of calculating the checksum of a data block comprises using the total number of bits of the data segments comprised in the respective data block and at least a checksum calculated for a preceding data block and/or a data segment checksum calculated for a preceding data segment not comprised in the formed data blocks.

**17.** The method according to any one of claims 11 to 16, further comprising the steps of:

   calculating a checksum for at least one of the data segments that are comprised in a data block by using the total number of bits of the respective data segment, and producing a data segment checksum value for the respective data segment; and
   attaching the data segment checksum value to the respective data segment.

**18.** The method according to any one of claims 1 to 17, wherein
   in the attaching step only a portion of the respective checksum value is attached to the respective data segments except for the last data segment.

**19.** The method according to any one of claims 1 to 18, wherein
   each data segment of the n data segments are consecutive, non-overlapping data segments of a predetermined size and wherein the first data segment is the left-most data segment of the segmented input data.

**20.** Apparatus for generating a checksum value for data input in a digital system, the apparatus comprising:

   a processing section for dividing the input data into n data segments indexed 1 to n, n being an integer;
   a check-sum calculator for calculating a first checksum for a first data segment of the n data segments using a total number of bits of the first data segment and producing a first checksum value and for calculating a checksum for at least a data segment indexed k of the n data segments and producing a checksum value indexed k, said checksum for data segment indexed k being calculated using the total number of bits of the data segments 1 to k, wherein k is an integer; and

an attaching section for attaching the first checksum value to the first data segment and said checksum value indexed k to the data segment indexed k.

21. Apparatus for generating a checksum value for data input in a digital system, the apparatus comprising:

a processing section for dividing the input data into n data segments, n being an integer, and forming at least one data block comprising at least two consecutive data segments;

a checksum calculator for calculating a checksum for the at least one data block by using the total number of bits of the data segments comprised in the respective data block, and producing a checksum value for the respective data block; and

an attaching section for attaching the checksum value to a last data segment comprised in the respective data block.

FIG. 1

EP 2 026 470 A1

200

Transport block

| CRC attachment | ~S210 |

| Code block segmentation | ~S220 |

| Channel coding | ~S230 |

(a) CRC per transport block

# FIG. 2

Transport block

300

Code block segmentation ～S310

CRC attachment ～S320

Channel coding ～S330

(b) CRC per code block segment

FIG. 3

400

401 — Segment 1
402 — Segment 2
403 — Segment 3
404 — Segment 4

CRC 1 ～410
CRC 2 ～420
CRC 3 ～430
CRC 4 ～440

FIG. 4

500

DIVIDE AN INPUT DATA BLOCK
INTO N DATA SEGMENTS ⟶ S510

CALCULATE A CRC FOR A
FIRST DATA SEGMENT ⟶ S520

CALCULATE A K-TH CRC FOR EACH
DATA SEGMENT K ⟶ S530

ATTACH THE 1ST CRC TO THE 1ST
DATA SEGMENT AND EACH K-TH
CRC TO EACH DATA SEGMENT K ⟶ S540

FIG. 5

Information bits: $u = [u_0 \; u_1 \; u_2 \ldots u_{m-2} \; u_{m-1}]$

CRC polynomial: $g(x) = g_0 + g_1{}^*x + g_2{}^*x^2 + g_3{}^*x^3 + g_4{}^*x^4 + x^5$

CRC bits: $r = [r_0 \; r_1 \; r_2 \; r_3 \; r_4]$

| Segment 4 | $u_0$ | $u_1$ | ... | $u_{m-2}$ | $u_{m-1}$ | ~604 |
| Segment 3 | $u_0$ | $u_1$ | ... | $u_{m-2}$ | $u_{m-1}$ | ~603 |
| Segment 2 | $u_0$ | $u_1$ | ... | $u_{m-2}$ | $u_{m-1}$ | ~602 |
| Segment 1 | $u_0$ | $u_1$ | ... | $u_{m-2}$ | $u_{m-1}$ | ~601 |

600

FIG. 6

|  | Solution (a) (Prior Art) | Solution (b) (Prior Art) | Solution (a) + (b) (Prior Art) | Proposed Solution |
|---|---|---|---|---|
| 2 segments | 0,19% to 0,39% | 0,39% to 0,78% | 0,32% to 0,65% | 0,39% to 0,78% |
| 3 segments | 0,13% to 0,19% | 0,58% to 0,78% | 0,26% to 0,39% | 0,58% to 0,78% |
| 4 segments | 0,09% to 0,13% | 0,52% to 0,78% | 0,22% to 0,30% | 0,52% to 0,78% |
| 5 segments | 0,07% to 0,09% | 0,48% to 0,78% | 0,20% to 0,26% | 0,48% to 0,78% |
| 6 segments | 0,06% to 0,07% | 0,46% to 0,78% | 0,19% to 0,23% | 0,46% to 0,78% |
| 7 segments | 0,05% to 0,06% | 0,45% to 0,78% | 0,18% to 0,21% | 0,45% to 0,78% |
| 8 segments | 0,04% to 0,05% | 0,44% to 0,78% | 0,17% to 0,20% | 0,44% to 0,78% |

## FIG. 7

810 { 801 — Segment 1
802 — Segment 2 } CRC 1 — 830

820 { 803 — Segment 3
804 — Segment 4 } CRC 2 — 840

**FIG. 8**

901 — Segment 1    CRC 1 — 910
902 — Segment 2    CRC 2 — 920
903 — Segment 3    CRC 3 — 930
904 — Segment 4    CRC 4 — 940

**FIG. 9**

1000

DIVIDE AN INPUT DATA BLOCK
INTO N DATA SEGMENTS — S1010

FORM AT LEAST A DATA BLOCK
COMPRISING AT LEAST TWO
CONSECUTIVE DATA SEGMENTS — S1020

CALCULATE A CRC
FOR EACH DATA BLOCK — S1030

ATTACH EACH
CRC TO A DATA SEGMENT
COMPRISED IN THE DATA BLOCK — S1040

FIG. 10

**European Patent Office**

## EUROPEAN SEARCH REPORT

Application Number

EP 07 01 6210

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | NTT DOCOMO: "R1-072927" 3GPP TSG RAN WG1 MEETING #49BIS, [Online] 29 June 2007 (2007-06-29), pages 1-4, XP002492528 Retrieved from the Internet: URL:http://www.3gpp.org/ftp/tsg_ran/WG1_RL 1/TSGR1_49b/Docs/> [retrieved on 2008-08-18] * the whole document * | 1-21 | INV. H03M13/09 H04L1/00 |
| D,A | 3GPP: "3GPP TS 36.212 V1.3.0" 3GPP, [Online] July 2007 (2007-07), pages 1-20, XP002492529 Retrieved from the Internet: URL:http://www.3gpp.org/FTP/Specs/archive/ 36%5Fseries/36.212/> [retrieved on 2008-08-18] * figure x * | 1-21 | |
| D,A | 3GPP: "3GPP TS 36.300 V8.1.0"[Online] June 2007 (2007-06), pages 1-106, XP002492530 Retrieved from the Internet: URL:http://www.3gpp.org/ftp/Specs/archive/ 36%5Fseries/36.300/> [retrieved on 2008-08-18] * figure 5.4.1.1 * | 1-21 | TECHNICAL FIELDS SEARCHED (IPC) H03M H04L |

The present search report has been drawn up for all claims

| Place of search | Date of completion of the search | Examiner |
|---|---|---|
| The Hague | 19 August 2008 | Van Staveren, Martin |

EPO FORM 1503 03.82 (P04C01)

**REFERENCES CITED IN THE DESCRIPTION**

**Patent documents cited in the description**

- US 5282215 A
- US 7243289 B